Europäisches Patentamt

European Patent Office

Office européen des brevets

(11) Veröffentlichungsnummer: **0 457 929 A1**

## (12) EUROPÄISCHE PATENTANMELDUNG

(21) Anmeldenummer: 90108133.1

(22) Anmeldetag: 27.04.90

(51) Int. Cl.5: **H01L 39/24**

(43) Veröffentlichungstag der Anmeldung:
27.11.91 Patentblatt 91/48

(84) Benannte Vertragsstaaten:
AT CH DE FR GB IT LI NL SE

(71) Anmelder: SIEMENS AKTIENGESELLSCHAFT
Wittelsbacherplatz 2
W-8000 München 2(DE)

(72) Erfinder: Günther, Andreas, Dipl.-Ing.
Geschwister-Scholl-Strasse 6
W-8520 Erlangen(DE)
Erfinder: Assmann, Helmut, Dr. Dipl.-Phys.
Schwabachstrasse 13
W-8524 Dormitz(DE)
Erfinder: Tenbrink, Johannes, Dr. Dipl.-Ing.
Rappacher Weg 36
W-8752 Mömbris(DE)

(54) Verfahren zum Herstellen eines hochtemperatur-supraleitenden Bauteiles und hochtemperatur-supraleitendes Bauteil.

(57) Die Erfindung betrifft ein Verfahren zum Herstellen eines hochtemperatur-supraleitenden Bauteiles, wobei ein zur Bildung eines Hochtemperatur-Supraleiters (2, 12) geeignetes Oxid bearbeitet wird. Ein geeignetes Oxid ist z.B. Bi-Sr-Ca-Cu-Oxid oder Y-Ba-Cu Oxid oder Seltene Erde-Ba-Cu-Oxid oder Tl-Ba-Ca-Cu-Oxid. Das bearbeitete Oxid wird mit einem Trägerkörper in Kontakt gebracht und der mit dem bearbeiteten Oxid versehene Trägerkörper wird in eine langgestreckte Raumform gebracht. Es ist vorgesehen, daß das Oxid in eine Glasschmelze umgewandelt wird, daß die Glasschmelze auf den Trägerkörper aufgebracht wird, wo sie zu einem Glas erstarrt, daß der mit dem Glas versehene Trägerkörper bei erhöhter Temperatur in eine langgestreckte Raumform gebracht wird und daß danach das Glas in eine bei Kühlung hochtemperatur-supraleitende Form überführt wird. Bei einem mit einem solchen Verfahren hergestellten hochtemperatur-supraleitenden Bauteil ist ein in hochtemperatur-supraleitender Form vorliegendes Glas vom Trägerkörper gehalten. Das fertige Bauteil kann beispielsweise ein Draht oder ein Band sein. Es kann einsetzbar sein zum Bau einer Elektrizitätsversorgungsleitung oder zum Bau von Spulen.

FIG 2

Die Erfindung betrifft ein Verfahren zum Herstellen eines hochtemperatur-supraleitenden Bauteiles, wobei ein zur Bildung eines Hochtemperatur-Supraleiters geeignetes Oxid, insbesondere Bi-Sr-Ca-Cu-Oxid oder Y-Ba-Cu-Oxid oder Seltene Erde-Ba-Cu-Oxid oder Tl-Ba-Ca-Cu-Oxid, bearbeitet wird, das bearbeitete Oxid mit einem Trägerkörper in Kontakt gebracht wird und der mit dem bearbeiteten Oxid versehene Trägerkörper in eine langgestreckte Raumform gebracht wird. Die Erfindung betrifft auch ein mit einem derartigen Verfahren hergestelltes hochtemperatur-supraleitendes Bauteil, das insbesondere eine Leitung ist.

Damit die Hochtemperatur-Supraleitung einsetzbar ist für die Energietechnik (Elektrizitätsversorgung) oder für die Magnetfeldtechnik (Spulen), ist es notwendig, einen Verbund aus supraleitender Keramik, die aus geeigneten Oxiden gebildet ist, und einem Trägerkörper zu bilden. Ein solcher Trägerkörper besteht beispielsweise aus Metall. Im Verbund gewährleistet der Trägerkörper eine mechanische Stabilität, die allein durch eine Keramik nicht gegeben wäre. Darüber hinaus gewahrt der Trägerkörper eine elektrische Stabilität, da bei einer Unterbrechung der supraleitenden Keramik ein Strom weiterhin durch den Trägerkörper fließen kann.

Sowohl für die Energietechnik, als auch für die Magnetfeldtechnik sind supraleitende, lange, drahtförmige oder bandförmige Leitungen erforderlich. Dabei darf der supraleitende Stoff keine Lücken aufweisen und muß mit dem Trägerkörper eng verbunden sein.

Ein Verfahren zum Herstellen von Drähten oder Bändern, die hochtemperatur-supraleitend sind, ist in der WO 89/06053 beschrieben. Dabei wird ein aus Oxiden bestehendes Keramikpulver, das für die Hochtemperatur-Supraleitung geeignet ist, kalt oder heiß isostatisch gepreßt. Der so gewonnene Keramik-Rohling kann in ein Hüllrohr eingebracht werden. Es kann aber auch bereits das Pressen in einem Hüllrohr erfolgen. Danach wird der Verbund aus Keramik und Hüllrohr einer Wärmebehandlung unterzogen. Daran schließt sich ein Umformschritt an. Durch Ziehen oder Walzen wird aus dem Verbund ein Draht oder Band geformt.

Beim isostatischen Pressen bleibt die Pulverform der eingebrachten Oxide erhalten. Das Oxidpulver wird nur verdichtet. Das anschließende Strangpressen des Verbundes aus verdichtetem Oxidpulver und Hüllrohr muß gleichförmig mit hoher Präzision erfolgen, damit ein Durchreißen des sich bildenden Pulverstranges ausgeschlossen bleibt. Anschließend ist ein Glühvorgang erforderlich, um das Pulver zu einer Keramik zu verbinden, die einen durchgehenden Stromtransport ermöglicht.

Der Erfindung lag die Aufgabe zugrunde, ein Verfahren zum Herstellen eines hochtemperatur-supraleitenden Bauteiles anzugeben, das das Herstellen dünner Drähte und Bänder ermöglicht. Das Verfahren soll mit einfachen Mitteln schnell und zuverlässig durchführbar sein, ohne daß nach Fertigstellung Lücken im hochtemperatur-supraleitenden Strang auftreten können. Selbst beim Herstellen dünner Drähte soll der später die Supraleitung tragende Strang nicht durchreißen können. Dabei soll man mit einer Glühung bei niedrigeren Temperaturen als beim Bekannten auskommen.

Es soll auch ein hochtemperatur-supraleitendes Bauteil, insbesondere eine Leitung, angegeben werden, das mit dem genannten Verfahren hergestellt ist.

Die erstgenannte Aufgabe wird gemäß der Erfindung dadurch gelöst, daß das Oxid in eine Glasschmelze umgewandelt wird, daß die Glasschmelze auf den Trägerkörper aufgebracht wird, wo sie zu einem Glas erstarrt, daß der mit dem Glas versehene Trägerkörper in eine langgestreckte Raumform gebracht wird und daß danach das Glas durch Wärmebehandlung in eine bei Kühlung hochtemperatur-supraleitende Form überführt wird.

Als erster Verfahrensschritt wird aus dem zur Bildung eines Hochtemperatur-Supraleiters geeigneten Oxid, bzw. aus der Oxidmischung, eine Glasschmelze gebildet. Dabei wird ausgenutzt, daß Oxide Bestandteile von Gläsern sind. Danach wird ein Rohling aus Trägerkörper und Glas hergestellt. Dabei läßt man die Glasschmelze auf der Oberfläche des Trägerkörpers zu einem Glas erstarren. Anschließend wird der Rohling aus Trägerkörper und Glas in eine langgestreckte Raumform gebracht. Als abschliessender Verfahrensschritt wird das Glas in eine bei Kühlung hochtemperatur-supraleitende Form überführt.

Eine Glasschmelze und auch ein erstarrtes Glas kann zusammen mit dem Trägerkörper gestreckt werden, ohne daß das Glas durchreißt. Das ist auch dann gegeben, wenn dünne Drähte oder Bänder hergestellt werden sollen, deren Durchmesser kleiner als 1 bis 2mm sind. Die Verformung kann, da ein Durchreißen des später hochtemperatur-supraleitenden Stranges nicht befürchtet werden muß, mit einfachen Mitteln schnell und zuverlässig durchgeführt werden. Die Wärmebehandlung kann bei niedrigerer Temperatur erfolgen als der Glühvorgang des bekannten Verfahrens.

Mit dem Verfahren nach der Erfindung wird der Vorteil erzielt, daß für die Energietechnik und für die Magnetfeldtechnik geeignete hochtemperatur-supraleitende Leitungen mit einfachen Mitteln und damit kostengünstig schnell und zuverlässig hergestellt werden können.

Der mit dem Glas versehene Trägerkörper kann beispielsweise zu einem Draht, einem Band oder einem Multifilamentleiter geformt werden. Man erhält dadurch geeignete Bauteile zum Aufbau supraleitender Leitungen. Solche Leitungen können für die Elektrizitätsversorgung eingesetzt werden. Beispielsweise können aus dem Draht, dem Band oder dem Multifilamentleiter Spulen hergestellt werden. Diese Spulen sind in der Magnetfeldtechnik einsetzbar.

Der Trägerkörper besteht beispielsweise aus Metall. Metall ist als Trägerkörper besonders geeignet, da es dem fertigen supraleitenden Bauteil mechanische Stabilität verleiht. Außerdem ist sichergestellt, daß, da ein Metall ein elektrischer Leiter ist, eine elektrische Stabilisierung durch den Trägerkörper gewährleistet ist für den Fall, daß der Hochtemperatur-Supraleiter durch magnetische Flußsprünge oder durch kurzfristige Temperaturerhöhungen lokal für kurze Zeit seine supraleitenden Eigenschaften verliert.

Beispielsweise besteht der Trägerkörper aus Kupfer, Aluminium oder Silber. Er kann auch aus Legierungen auf der Basis der genannten Metalle bestehen. Die genannten Metalle und Legierungen zeichnen sich dadurch aus, daß sie im Temperaturbereich, der für die Verformung des mit dem Glas versehenen Trägerkörpers vorgesehen ist, ausreichend duktil sind. Daher sind nur relativ kleine Kräfte für die Verformung erforderlich.

Vor der Umwandlung des Oxids, das für die Bildung eines Hochtemperatur-Supraleiters geeignet ist, in ein Glas, werden dem Oxid beispielsweise glasbildende oder keimbildende oder texturfördernde oder auch andere Additive zugegegeben. Derartige als solche bekannte Additive sind geeignet, die Bildung eines Hochtemperatur-Supraleiters zu erleichtern und zu beschleunigen. Der fertige hochtemperatur-supraleitendende Strang ist aufgrund der Additive qualitativ hochwertig. Es können auch Mischungen der genannten Additive zugegeben werden.

Beispielsweise weist der Trägerkörper einen Kanal auf und dieser Kanal wird mit der Glasschmelze gefüllt. Dabei wird die Schmelze bis zum Erstarren im Trägerkörper gehalten. Das nach geeigneter Wärmebehandlung fertige supraleitende Bauteil weist dann einen supraleitenden Kern auf, der von einer Metallhülle umgeben ist und damit gegen mechanische Einwirkungen von außen geschützt ist.

Nach einem anderen Beispiel weist der Trägerkörper mehrere Kanäle auf, die alle mit der Glasschmelze gefüllt werden. Man erhält damit ein supraleitendes Bauteil, bei dem in einem Metallkörper mehrere supraleitende Fasern angeordnet sind. Bei einem magnetischen Flußsprung oder bei lokaler Temperaturerhöhung in einer Faser stehen noch andere Fasern zur Verfügung.

Nach einem weiteren Beispiel weist der Trägerkörper eine Ausnehmung, z.B. eine trogartige Ausnehmung, auf, die mit der Glasschmelze gefüllt wird. Bei einer derartigen Ausgestaltung ist das Einfüllen der Glasschmelze besonders einfach durchzuführen.

Beispielsweise wird der Trägerkörper in die Glasschmelze eingetaucht, wodurch ein Überzug gebildet wird. Ein solches Tauchverfahren ist schneller durchführbar, als das Einfüllen der Schmelze in einen hohlen Trägerkörper. Beim Tauchverfahren bildet sich auf der gesamten Oberfläche des Trägerkörpers durch Adhäsion eine Glasschmelzeschicht. Das fertige Bauteil besteht dann aus einem metallischen Kern, der vom supraleitenden Material umgeben ist.

Alle nach geeigneter Wärmebehandlung fertigen supraleitenden Bauteile müssen, damit die Supraleitung gegeben ist, gekühlt werden. Dazu sind sie in einem Behälter, beispielsweise in einem Rohr, angeordnet, durch das ein Kühlmittel, wie flüssiger Stickstoff oder Helium, geleitet wird. Es kann aber auch der Trägerkörper mit Leitungsführungen für Kühlmittel durchzogen sein. Insbesondere kann der Trägerkörper rohrförmig ausgebildet sein.

Beispielsweise wird der mit dem Glas versehene Trägerkörper warm verformt, um ihm die gewünschte langgestreckte Raumform zu geben. Mit einer Warmverformung wird der Vorteil erzielt, daß beim Verformen die Verbindung von Metall und Glas nicht beeinträchtigt und das Glas ohne Zerstörung seines Zusammenhangs verformt wird.

Beispielsweise erfolgt die Warmverformung bei einer Temperatur zwischen der Glastransformationstemperatur $T_g$ und der Temperatur der ersten Kristallisation des Glases $T_x$. Die genannten Temperaturen sind bei jeder Glasverarbeitung zu beachtende bekannte Temperaturen. Sie hängen von der Glassorte ab. Beispielsweise erfolgt die Warmverformung bei einer Temperatur zwischen 200 °C und 550 °C. Eine besonders geeignete Temperatur für die Warmverformung liegt zwischen 400 °C und 550 °C. Im genannten Temperaturbereich ist das Glas, aber auch das Metall des Trägerkörpers gut verformbar. Damit wird der Vorteil erzielt, daß bei der Verformung Glas und Metall stets aneinander haften. Eine Unterbrechung der später supraleitenden Schicht aufgrund des Verformungsvorganges ist nicht zu erwarten.

Die verwendeten Metalle und Metallegierungen für den Trägerkörper weisen bei den genannten Temperaturen eine ähnliche Verformbarkeit wie das Glas auf. Dadurch ist es möglich, einen langgestreckten Körper, beispielsweise einen Draht oder ein Band zu bilden.

Die Warmverformung des mit dem Glas versehenen Trägerkörpers erfolgt beispielsweise durch Strangpressen oder Warmziehen oder Warmwalzen oder Warmpilgern. Alle genannten Verfahren ergeben geeignete Bauteile.

Der Trägerkörper kann durch eine geeignete Vorrichtung mechanisch stabilisiert sein. Eine solche geeignete Vorrichtung ist beispielsweise ein Stahldraht, der sich im Trägerkörper befindet und dessen thermische Ausdehnung derjenigen thermischen Ausdehnung des mit dem Glas versehenen Trägerkörpers angepaßt ist. Durch den Stahldraht ist die mechanische Stabilität des fertigen Bauteiles vergrößert.

Nachdem der mit dem Glas versehene Trägerkörper in eine langgestreckte Raumform gebracht worden ist, wird dieser beispielsweise zunächst bei einer Keimbildungstemperatur und dann bei einer Kristallisationstemperatur behandelt, wodurch eine hochtemperatursupraleitende Phase des Glases gebildet wird. Bei der Keimbildungstemperatur bilden sich in dem zunächst amorphen Glas erste kristalline Keime, die dann bei der höheren Kristallisationstemperatur zu einem Auskristallisieren des gesamten Glases führen. Erst dann liegt ein bei Kühlung hochtemperatur-supraleitender Stoff vor. Eine übliche Keimbildungstemperatur liegt zwischen 300 °C und 400 °C. Eine übliche Kristallisationstemperatur liegt zwischen 750 °C und 880 °C.

Die zweitgenannte Aufgabe, ein hochtemperatur-supraleitendes Bauteil, insbesondere eine Leitung, das / die aus einem Trägerkörper und einem einen Hochtemperatur-Supraleiter bildenden Oxid mit dem Verfahren nach der Erfindung hergestellt ist, anzugeben, wird gemäß der Erfindung dadurch gelöst, daß ein in hochtemperatur-supraleitende Form überführtes Glas vom Trägerkörper gehalten ist. Das hochtemperatur-supraleitende Bauteil ist beispielsweise ein Rohr als Trägerkörper, das vom Hochtemperatur-Supraleiter ausgefüllt ist. Das Bauteil kann auch ein Stab mit Längskanälen sein oder ein Stab mit einer in Längsrichtung verlaufenden Ausnehmung. Kanäle und Ausnehmung sind dabei vom Hochtemperatur-Supraleiter ausgefüllt. Es ist auch möglich, daß der Trägerkörper ein Stab ist, der vom Hochtemperatur-Supraleiter umschlossen ist.

Alle genannten Ausführungsformen für ein hochtemperatur-supraleitendes Bauteil können entweder in einer kühlmittelführenden Leitung angeordnet sein, oder selbst eine Einrichtung zur Aufnahme von Kühlmittel beinhalten. Dazu kann der Trägerkörper entweder ein Rohr sein oder Kühlmittelkanäle aufweisen. Das Bauteil kann auch in einem Badkyrostat angeordnet sein. Dann sind keine Kühlmittelkanäle oder Kühlmittelleitungen, die dem Bauteil zugeordnet sind, erforderlich. Ein für die Hochtemperatur-Supraleitung geeignetes Kühlmittel ist flüssiger Stickstoff oder flüssiges Helium.

Der Trägerkörper kann durch eine Vorrichtung, beispielsweise durch einen in ihm in Längsrichtung verlaufend angeordneten Stahldraht, stabilisiert sein.

Mit dem Verfahren und mit dem hochtemperatur-supraleitenden Bauteil nach der Erfindung wird der Vorteil erzielt, daß Bauteile mit langgestreckter Raumform, beispielsweise Leitungen, mit kleinem Querschnitt schnell und zuverlässig herzustellen sind. Dabei ist gewährleistet, daß während des Herstellens die Verbindung zwischen dem später supraleitenden Bestandteil der Leitung und dem metallischen Trägerkörper nicht beeinträchtigt oder sogar unterbrochen wird. Mit dem geschilderten Verfahren sind kostengünstige hochtemperatur-supraleitende Leitungen herzustellen, die vielseitig verwendbar sind.

Beispiele für das Verfahren und für ein Bauteil nach der Erfindung werden anhand der Zeichnung näher erläutert:

Die Zeichnung zeigt mit dem Verfahren nach der Erfindung hergestellte hochtemperatur-supraleitende Verbindungsleitungen.

FIG 1   zeigt ein metallisches Rohr als Trägerkörper, das mit einem Hochtemperatur-Supraleiter ausgefüllt ist, in einer Kühlmittel führenden Leitung;

FIG 2   zeigt einen metallischen Stab als Trägerkörper, der mit einem Hochtemperatur-Supraleiter ausgefüllte Längskanäle und einen Kühlmittelkanal aufweist;

FIG 3   zeigt einen stabförmigen Trägerkörper aus Metall, mit einer Ausnehmung, die mit einem Hochtemperatur-Supraleiter ausgefüllt ist, und mit Kühlkanälen;

FIG 4   zeigt einen metallischen Trägerkörper, der von einem Hochtemperatur-Supraleiter umschlossen ist, und einen Kühlkanal aufweist.

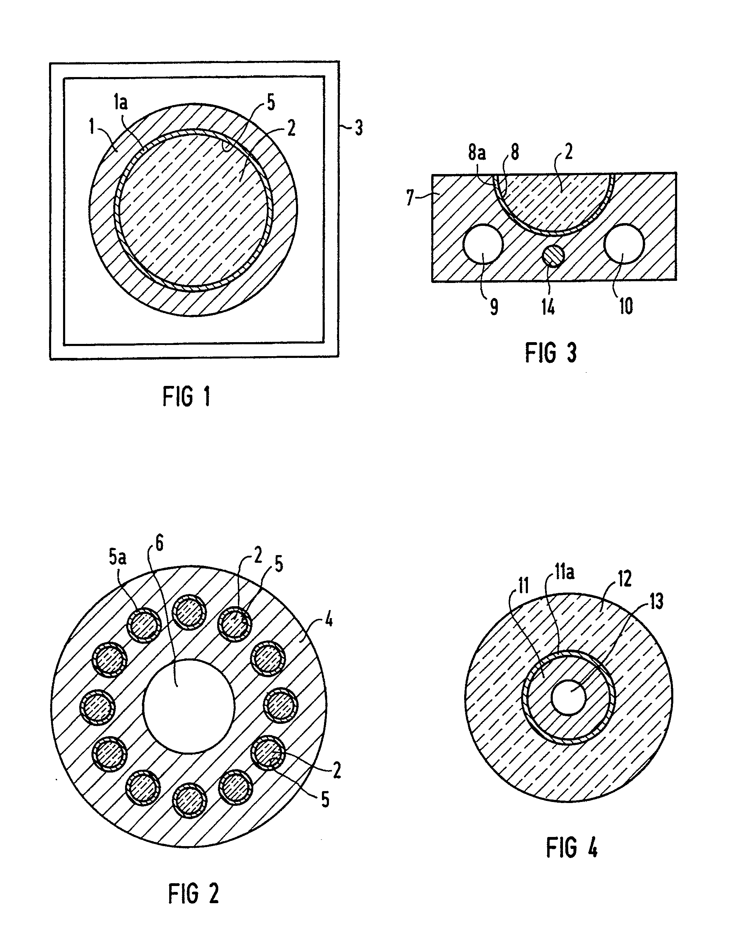

Das hochtemperatur-supraleitende Bauteil nach FIG 1 besteht aus einem metallischen Rohr 1 als Trägerkörper. Das Innere des Rohres 1, das einen Längskanal 5 darstellt, ist mit einem Hochtemperatur-Supraleiter 2 ausgefüllt. Dabei dient das Rohr 1 einerseits der mechanischen Stabilisierung des Supraleiters 2 und gewährleistet außerdem bei einer Unterbrechung des Supraleiters 2 die Aufrechterhaltung einer elektrisch leitenden Verbindung. Zur Verhinderung einer Diffusionsbewegung zwischen dem Hochtemperatur-Supraleiter 2 und dem metallischen Rohr 1 kann das Rohr 1 innen mit einer Diffusionsbarriere ausgekleidet sein, die ein dünnes Silberrohr 1a sein kann. Damit eine Supraleitung möglich ist, befindet sich das Rohr 1 mit dem Supraleiter 2 in einer Kühlmittelleitung 3, die mit einem Kühlmittel, beispielsweise flüssigem Stickstoff, durchströmt wird. An die Stelle der Kühlmittelleitung 3 kann auch ein Badkryostat treten, in dem das Kühlmittel nicht strömt sondern ruht. Zur Bildung des Bauteiles, das aus dem Rohr 1 und dem Hochtemperatur-Supraleiter 2 besteht, ist zunächst ein geeignetes Oxid, z.B. Bi-Sr-Ca-Cu-Oxid oder Y-Ba-Cu-Oxid oder Seltene Erde-Ba-Cu-Oxid oder Tl-Ba-Ca-Cu-Oxid in eine Glasschmelze umgewandelt worden. Diese Glasschmelze ist in ein Rohr mit größerem Durchmesser als das Rohr 1 eingefüllt worden. Dort ist die Glasschmelze zu einem Glas erstarrt. Danach wurde das gefüllte Rohr, beispielsweise durch Strangpressen, warm verformt, wodurch das in Figur 1 gezeigte Rohr 1 gebildet wurde. Danach wurde durch eine Wärmebehandlung das Glas im Rohr 1 in den Hochtemperatur-Supraleiter 2 umgewandelt.

Nach Figur 2 ist der Trägerkörper ein Stab 4 aus Metall, der mehrere Längskanäle 5 aufweist. Diese Längskanäle 5 können mit dünnen Silberrohren 5a als Diffusionsbarrieren ausgekleidet sein und sind mit einem Hochtemperatur-Supraleiter 2 angefüllt. Im Stab 4 kann sich außerdem eine zentrale Längsbohrung befinden, die als Kühlkanal 6 dient und beispielsweise flüssigen Stickstoff aufnimmt.

Eine weitere Ausführungsform nach Figur 3 sieht als Trägerkörper einen Stab 7 aus Metall vor. In diesem Stab 7 befindet sich eine in Längsrichtung verlaufende Ausnehmung 8, die mit einer Silberschicht 8a als Diffusionsbarriere ausgekleidet sein kann und mit einem Hochtemperatur-Supraleiter 2 gefüllt ist. Zum mechanischen Stabilisieren ist im Stab 7 verlaufend ein Stahldraht 14 angeordnet. Im Stab 7 können sich zwei Kühlkanäle 9 und 10 befinden. Beide führen im Betriebszustand ein Kühlmittel, beispielsweise flüssigen Stickstoff.

Nach Figur 4 ist der Trägerkörper aus Metall ein Stab 11, der von einem Silberrohr 11a als Diffusionsbarriere umgeben sein kann. Dieser ist von einem Hochtemperatur-Supraleiter 12 umgeben. Zur Bildung einer solchen Kombination wurde der Trägerkörper nicht mit einer Glasschmelze gefüllt, sondern wurde in die Glasschmelze eingetaucht, wobei sich durch Adhäsion ein Überzug aus Glasschmelze auf dem Trägerkörper bildet. Der Stab 11 kann einen Kühlkanal 13 enthalten zur Aufnahme eines Kühlmittels, wie flüssiger Stickstoff. Dazu kann der Stab 11 beispielsweise als Rohr ausgebildet sein.

Die Bauteile nach den Figuren 2 bis 4 können statt Kühlkanäle 6, 9, 10, 13 aufzuweisen, wie in Figur 1 gezeigt, in einer Kühlmittelleitung 3 angeordnet sein. Ebenso kann das Bauteil nach Figur 1 statt mit einer Kühlmittelleitung 3 mit einem oder mehreren Kühlkanälen ausgestattet sein. Auch ein gleichzeitiger Einsatz von Kühlmittelleitung und Kühlkanal ist möglich.

Die Trägerkörper nach den Figuren 1, 2 und 4 können wie bei Figur 3 gezeigt, einen Stahldraht 14 zum Stabilisieren beinhalten. Der Trägerkörper nach Figur 3 kann auch ohne Stahldraht 14 auskommen.

Bei den in den Figuren gezeigten Kombinationen aus Trägerkörper und Hochtemperatur-Supraleiter 2, 12 wird aus Oxiden, aus denen ein Hochtemperatur-Supraleiter 2, 12 gebildet werden kann, zunächst eine Glasschmelze hergestellt, die dann mit dem Trägerkörper in Kontakt gebracht wird. Dort erstarrt die Glasschmelze zu einem Glas. Erst danach wird die so gewonnene Kombination aus metallischem Trägerkörper und Glas durch mechanische Verfahren in eine langgestreckte Raumform, beispielsweise in die Form eines Drahtes, gebracht. Dabei bleibt die enge Verbindung von Metall und Glas erhalten. Erst wenn das mechanische Verfahren abgeschlossen ist und die gewünschte Raumform vorliegt, wird das Glas, das mit dem metallischen Trägerkörper fest verbunden ist, in eine hochtemperatur-supraleitende Form überführt. Dazu dient z.B. eine Wärmebehandlung in einer sauerstoffhaltigen Atmosphäre.

Die in den Figuren 1 bis 4 gezeigten hochtemperatur-supraleitenden Bauteile sind mit einfachen Mitteln herstellbar und gewährleisten eine zuverlässige ununterbrochene hochtemperatur supraleitende Leitungsverbindung.

**Patentansprüche**

1.   Verfahren zum Herstellen eines hochtemperatur-supraleitenden Bauteiles, wobei ein zur Bildung eines Hochtemperatur-Supraleiters (2, 12) geeignetes Oxid, insbesondere Bi-Sr-Ca-Cu-Oxid oder Y-Ba-Cu-Oxid oder Seltene Erde-Ba-Cu-Oxid oder Tl-Ba-Ca-Cu-Oxid, bearbeitet wird, das bearbeitete Oxid mit einem Trägerkörper in Kontakt gebracht wird und der mit dem bearbeiteten Oxid versehene Trägerkörper in eine langgestreckte Raumform gebracht wird,
**dadurch gekennzeichnet,** daß das Oxid in eine Glasschmelze umgewandelt wird, daß die Glasschmelze auf den Trägerkörper aufgebracht wird, wo sie zu einem Glas erstarrt, daß der mit dem Glas versehene Trägerkörper in eine langgestreckte Raumform gebracht wird und daß danach das Glas durch Wärmebehandlung in eine bei Kühlung hochtemperatur-supraleitende Form überführt wird.

2.   Verfahren nach Anspruch 1,
**dadurch gekennzeichnet,** daß der mit Glas versehene Trägerkörper zu einem Draht oder einem Band oder einem Multifilamentleiter geformt wird.

3. Verfahren nach Anspruch 2,
   **dadurch gekennzeichnet,** daß eine Spule gebildet wird.

4. Verfahren nach einem der Ansprüche 1 bis 3,
   **dadurch gekennzeichnet,** daß der Trägerkörper aus Metall besteht.

5. Verfahren nach Anspruch 4,
   **dadurch gekennzeichnet,** daß der Trägerkörper aus Kupfer oder Aluminium oder Silber oder einer Legierung auf der Basis von Kupfer, Aluminium oder Silber besteht.

6. Verfahren nach einem der Ansprüche 1 bis 5,
   **dadurch gekennzeichnet,** daß vor der Umwandlung des Oxids in ein Glas glasbildende oder keimbildende oder texturfördernde oder andere Additive zugegeben werden.

7. Verfahren nach einem der Ansprüche 1 bis 6,
   **dadurch gekennzeichnet,** daß der Trägerkörper einen oder mehrere Längskanäle (5) aufweist und daß der Längskanal (5) oder die Längskanäle (5) mit der Glasschmelze gefüllt wird/ werden.

8. Verfahren nach einem der Ansprüche 1 bis 6,
   **dadurch gekennzeichnet,** daß der Trägerkörper eine Ausnehmung (8) aufweist, die mit der Glasschmelze gefüllt wird.

9. Verfahren nach einem der Ansprüche 1 bis 6,
   **dadurch gekennzeichnet,** daß der Trägerkörper in die Glasschmelze eingetaucht wird, wodurch ein Überzug gebildet wird.

10. Verfahren nach einem der Ansprüche 1 bis 9,
    **dadurch gekennzeichnet,** daß der mit dem Glas versehene Trägerkörper warm verformt wird.

11. Verfahren nach Anspruch 10,
    **dadurch gekennzeichnet,** daß die Warmverformung bei einer Temperatur zwischen der Glastransformationstemperatur $T_g$ und der Temperatur der ersten Kristallisation des Glases $T_x$ erfolgt.

12. Verfahren nach Anspruch 11,
    **dadurch gekennzeichnet,** daß die Warmverformung bei einer Temperatur zwischen 200° C und 550° C erfolgt.

13. Verfahren nach Anspruch 12,
    **dadurch gekennzeichnet,** daß die Warmverformung bei einer Temperatur zwischen 400° C und 550° C erfolgt.

14. Verfahren nach einem der Ansprüche 10 bis 13,
    **dadurch gekennzeichnet,** daß der mit dem Glas versehene Trägerkörper durch Strangpressen oder Warmziehen oder Warmwalzen oder Warmpilgern warm verformt wird.

15. Verfahren nach einem der Ansprüche 1 bis 14,
    **dadurch gekennzeichnet,** daß der Trägerkörper eine Vorrichtung zum mechanischen Stabilisieren enthält.

16. Verfahren nach Anspruch 15,
    **dadurch gekennzeichnet,** daß die Vorrichtung zum Stabilisieren ein Stahldraht (14) mit einer thermischen Ausdehnung ist, die an die thermische Ausdehnung des mit dem Glas versehenen Trägerkörpers angepaßt ist.

17. Verfahren nach einem der Ansprüche 1 bis 16,
    **dadurch gekennzeichnet,** daß, nachdem der mit dem Glas versehene Trägerkörper in eine langgestreckte Raumform gebracht worden ist, dieser zunächst bei einer Keimbildungstemperatur und dann bei einer Kristallisationstemperatur behandelt wird, wodurch eine hochtemperatur-supraleitende Phase des Glases gebildet wird.

18. Hochtemperatur-supraleitendes Bauteil, insbesondere Leitung, gebildet aus einem Trägerkörper und einem einen Hochtemperatur-Supraleiter (2, 12) bildenden Oxid, hergestellt mit einem Verfahren, vorzugsweise nach einem der Ansprüche 1 bis 17,
    **dadurch gekennzeichnet,** daß ein Glas in hochtemperatur-supraleitender Form vom Trägerkörper gehalten ist.

19. Hochtemperatur-supraleitendes Bauteil nach Anspruch 18,
    **dadurch gekennzeichnet,** daß der Trägerkörper ein Stab (4) mit einem oder mehreren Längskanälen (5) ist, die vom Glas als Hochtemperatur-Supraleiter (2) ausgefüllt sind.

20. Hochtemperatur-supraleitendes Bauteil nach einem der Ansprüche 18 oder 19,
    **dadurch gekennzeichnet,** daß der Trägerkörper ein Rohr (1) ist, das vom Glas als Hochtemperatur-Supraleiter (2) ausgefüllt ist.

21. Hochtemperatur-supraleitendes Bauteil nach Anspruch 18,
    **dadurch gekennzeichnet,** daß der Trägerkörper ein Stab (7) mit einer in Längsrichtung verlaufenden Ausnehmung (8) ist, die vom Glas als Hochtemperatur-Supraleiter (2) ausgefüllt ist.

22. Hochtemperatur-supraleitendes Bauteil nach Anspruch 18,
**dadurch gekennzeichnet,** daß der Trägerkörper ein Stab (11) ist, der vom Glas als Hochtemperatur-Supraleiter (12) umschlossen ist.

23. Hochtemperatur-supraleitendes Bauteil nach einem der Ansprüche 18 bis 22,
**dadurch gekennzeichnet,** daß der Trägerkörper Kühlkanäle (6, 9, 10, 13) zur Aufnahme eines Kühlmittels aufweist.

24. Hochtemperatur-supraleitendes Bauteil nach einem der Ansprüche 18 bis 23,
**dadurch gekennzeichnet,** daß der mit dem Glas versehene Trägerkörper in einer Kühlmittelleitung (3), die zur Aufnahme eines Kühlmittels dient, angeordnet ist.

25. Hochtemperatur-supraleitendes Bauteil nach einem der Ansprüche 22 oder 23, **dadurch gekennzeichnet,** daß das Kühlmittel flüssiger Stickstoff oder flüssiges Helium ist.

26. Hochtemperatur-supraleitendes Bauteil nach einem der Ansprüche 18 bis 25,
**dadurch gekennzeichnet,** daß der Trägerkörper eine Vorrichtung zum Stabilisieren enthält.

27. Hochtemperatur-supraleitendes Bauteil nach Anspruch 26,
**dadurch gekennzeichnet,** daß die Vorrichtung zum Stabilisieren ein Stahldraht (14) ist.

FIG 1

FIG 3

FIG 2

FIG 4

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | JAPANESE JOURNAL OF APPLIED PHYSICS, Band 29, Nr. 1, Januar 1990, Seiten L64-L66, Tokyo, JP; M. ONISHI et al.: "Bi-Pb-Sr-Ca-Cu-O superconducting fibers drawn from melt-quenched glass preforms" * Seite L64, Absätze 2-4 * | 1-2,10-14 | H 01 L 39/24 |
| A | IEEE TRANSACTIONS ON MAGNETICS, Band 25, Nr. 2, März 1989, Seiten 2150-2153, New York, US & APPLIED SUPERCONDUCTIVITY CONFERENCE, 21. August 1988, San Francisco, US; T. KOMATSU et al.: "High-Tc superconducting glass ceramics based on the Bi-Ca-Sr-Cu-O system" * Seite 2150, Absätze 3-5 * | 1-2,4,6 | |
| A | EP-A-0 297 061 (SAES GETTERS) * Spalte 1, Zeilen 56-63; Spalte 2, Zeilen 1-37 * | 22-26 | |
| P,X | EP-A-0 369 464 (SUMITOMO) * Spalte 3, Zeilen 30-58; Spalte 4, Zeilen 1-12,34-58; Spalte 5, Zeilen 1-17 * | 1-4,6, 10-14 | |
| P,X | EP-A-0 390 499 (NGK INSULATORS) * Seite 3, Zeilen 33-57; Seite 4, Zeilen 9-16; Seite 5, Zeilen 13-41; Seite 15, Ansprüche 9-11 * | 1,4-6 | |

| RECHERCHIERTE SACHGEBIETE (Int. Cl.5) |
|---|
| H 01 L 39 |

Der vorliegende Recherchenbericht wurde für alle Patentansprüche erstellt

| Recherchenort | Abschlußdatum der Recherche | Prüfer |
|---|---|---|
| Den Haag | 19 November 90 | HAMMEL E.J. |